# EUROPÄISCHE PATENTANMELDUNG

(11) **EP 3 343 600 A1**
(43) Veröffentlichungstag der Anmeldung: **04.07.2018**
(21) Anmeldenummer: 16207050.2
(22) Anmeldetag: 28.12.2016
(51) Int. Cl.: H01L 23/00, H01L 25/07

(54) **HALBLEITERMODUL MIT EINEM ERSTEN UND EINEM ZWEITEN VERBINDUNGSELEMENT ZUM VERBINDEN EINES HALBLEITERCHIPS SOWIE HERSTELLUNGSVERFAHREN**

(71) Anmelder: Siemens Aktiengesellschaft, 80333 München (DE)
(72) Erfinder: Zaiser, Georg, 91056 Erlangen (DE)

(57) **Zusammenfassung**

Die Erfindung betrifft ein Halbleitermodul (1) mit einem Substrat (2), mit einem Halbleiterchip (6), welcher auf dem Substrat (2) angeordnet ist, und mit einem ersten Verbindungselement (12) zum elektrischen Verbinden des Halbleiterchips (6) mit einer Leiterbahn (7) und/oder einem weiteren Bauelement des Halbleitermoduls (1), wobei das erste Verbindungselement (12) zumindest bereichsweise flächig an dem Halbleiterchip (6) und dem Substrat (2) sowie der Leiterbahn (7) und/oder dem weiteren Bauelement anliegt, wobei das Halbleitermodul (1) ein zweites Verbindungselement (13) zum elektrischen Verbinden des Halbleiterchips (6) mit der Leiterbahn (7) und/oder dem weiteren Bauelement aufweist, wobei das zweite Verbindungselement (13) als Draht oder als Band ausgebildet ist.

## Beschreibung

Die Erfindung betrifft ein Halbleitermodul mit einem Substrat, mit einem Halbleiterchip, welcher auf dem Substrat angeordnet ist, und mit einem ersten Verbindungselement zum elektrischen Verbinden des Halbleiterchips mit einer Leiterbahn und/oder einem weiteren Bauelement des Halbleitermoduls, wobei das erste Verbindungselement zumindest bereichsweise flächig an dem Halbleiterchip und dem Substrat sowie der Leiterbahn und/oder dem weiteren Bauelement anliegt. Darüber hinaus betrifft die vorliegende Erfindung ein Verfahren zum Herstellen eines Halbleitermoduls.

Das Interesse richtet sich vorliegend auf Halbleitermodule, welche beispielsweise Teil einer Elektronik oder einer Leistungselektronik sein können. Derartige Halbleitermodule umfassen zumindest einen Halbleiterchip, welcher auf einem Substrat angeordnet ist. Dieser Halbleiterchip ist elektrisch mit weiteren Komponenten des Halbleitermoduls verbunden. Beispielsweise kann der Halbleiterchip mit einer oder mehreren Leiterbahnen, welche auf dem Substrat angeordnet sind, verbunden sein. Des Weiteren kann der Halbleiterchip elektrisch mit weiteren Bauteilen bzw. Halbleiterchips des Halbleitermoduls verbunden sein. Aus dem Stand der Technik sind unterschiedliche Verfahren zur elektrischen Kontaktierung des Halbleiterchips bekannt.

Eine häufig verwendete Form zur Kontaktierung von Halbleiterchips sind Bonddrähte. Hierbei ist aber die Kontaktstelle des Bonddrahtes an dem Halbleiterchip als eine Schwachstelle bekannt. Dies ist dadurch begründet, dass die Kontaktfläche verhältnismäßig klein ist. Darüber hinaus bringen Bonddrähte den Nachteil mit sich, dass elektromagnetische Störungen innerhalb des Halbleitermoduls auftreten können somit die elektromagnetische Verträglichkeit (EMV) nicht ausreichend gewährleistet ist. Zudem kann durch die Belastung in Bonddraht die Temperatur erhöht werden. Dies kann eine thermische Ausdehnung und damit eine mechanische Spannung verursachen. Dies kann dann zu einer Beschädigung führen.

Des Weiteren ist aus dem Stand der Technik die Kontaktierung von Halbleiterchips mit einem Band, welches auch als ribbon bezeichnet werden kann, bekannt. Da die einzelnen Bänder einen größeren Querschnitt aufweisen als Bonddrähte, wird für die Realisierung des gleichen Leiterquerschnitts im Vergleich zu Bonddrähten eine geringere Anzahl von Bändern benötigt. Die Kontaktierung der Bänder auf der Oberfläche des Halbleiterchips benötigt aber eine größere Fläche. Somit ist es nicht mehr möglich, eine bessere Stromtragfähigkeit zu realisieren. Auch die Einstrahlung von elektromagnetischen Störungen ist weiterhin nicht ausgeschlossen und es hat sich heraus gestellt, dass die Halbleitermodule in bestimmten Betriebszuständen zu Schwingungen neigen.

Ferner ist aus dem Stand der Technik die Verwendung von flexiblen Platten zur Kontaktierung von Halbleiterchips bekannt. Hierbei wird der Halbleiterchip großflächig durch ein vorgefertigtes Verbindungselement, welches beispielsweise als flexible Platte ausgebildet sein kann, kontaktiert. Somit wird es ermöglicht, die Kontaktfläche deutlich zu erhöhen. Der wirksame Querschnitt des Verbindungselements ist aber geringer als bei Bonddrähten. Dabei ist Verbesserung des wirksamen Querschnitts nur durch die Erhöhung der Schichtdicke des Verbindungselements bzw. der flexiblen Platte möglich.

Wenn aber das Verbindungselement dünn und flexibel ausgestaltet wird, so ist die Elastizität und die Ausdehnung des Verbindungselements gut und das Verbindungselement kann sich zusammen mit dem Halbleiterchip elastisch verformen, sodass keine bleibende Verformung des Verbindungselements verursacht wird. Die Stromtragfähigkeit des Verbindungselements ist aber wegen der geringen Schichtdicke nicht ausreichend. Es kann auch der Fall sein, dass sich der Temperaturhub innerhalb des Verbindungselements erhöht, sodass die Leistungsfähigkeit des Halbleiterchips nicht ausgenutzt werden kann. Falls die Schichtdicke des Verbindungselements aber erhöht wird, kann dies dazu führen, dass das Verbindungselement nicht mehr ausreichend flexibel ist, um sich zusammen mit dem Halbleiterchip bei Temperaturwechseln auszudehnen. Somit kann eine ausreichende Robustheit nicht garantiert werden.

Es ist Aufgabe der vorliegenden Erfindung, eine Lösung aufzuzeigen, wie eine elektrische Verbindung innerhalb eines Halbleitermoduls der eingangs genannten Art zuverlässiger ausgestaltet werden kann.

Diese Aufgabe wird erfindungsgemäß durch ein Halbleitermodul, sowie durch ein Verfahren mit den Merkmalen gemäß den jeweiligen unabhängigen Ansprüchen gelöst. Vorteilhafte Weiterbildungen der vorliegenden Erfindung sind Gegenstand der abhängigen Ansprüche.

Ein erfindungsgemäßes Halbleitermodul umfasst ein Substrat. Des Weiteren umfasst das Halbleitermodul einen Halbleiterchip, welcher auf dem Substrat angeordnet ist. Darüber hinaus umfasst das Halbleitermodul ein erstes Verbindungselement zum elektrischen Verbinden des Halbleiterchips mit einer Leiterbahn und/oder einem weiteren Bauelement des Halbleitermoduls, wobei das erste Verbindungselement zumindest bereichsweise flächig an dem Halbleiterchip und dem Substrat sowie der Leiterbahn und/oder dem weiteren Bauelement anliegt. Schließlich umfasst das Halbleitermodul ein zweites Verbindungselement zum elektrischen Verbinden des Halbleiterchips mit der Leiterbahn und/oder dem weiteren Bauelement, wobei das zweite Verbindungselement als Draht oder als Band ausgebildet ist.

Das Halbleitermodul kann beispielsweise für eine Leistungselektronik verwendet werden. Das Halbleitermodul umfasst das Substrat, welches aus einem elektrisch isolierenden Material gebildet sein kann. Bevorzugt ist das Substrat aus einer Keramik gefertigt. Auf diesem Substrat ist der Halbleiterchip angeordnet. Der Halbleiterchip, welcher auch als die bezeichnet werden kann, ist insbesondere ein ungehäustes Halbleiterbauelement. Der Halbleiterchip kann beispielsweise als Diode, als Transistoren oder dergleichen ausgebildet sein. Darüber hinaus kann das Halbleitermodul Leiterbahnen aufweisen, welche auf dem Substrat angeordnet sind bzw. welche auf das Substrat aufgebracht sind. Darüber hinaus kann das Halbleitermodul weitere Bauelemente bzw. elektronische Bauelemente aufweisen. Bei den weiteren Bauelementen kann es sich um weitere Halbleiterchips handeln. Außerdem umfasst das Halbleitermodul das erste elektrische Verbindungselement. Dieses erste elektrische Verbindungselement dient dazu, den Halbleiterchip mit einer Leiterbahn und/oder mit einem weiteren Bauelement elektrisch zu verbinden. Dabei ist das erste Verbindungselement so ausgebildet, dass es flächig an einem Bereich des Halbleiterchips und auch an einem Bereich des Substrats anliegt. Zudem kann das erste Verbindungselement flächig an einem Bereich der Leiterbahn oder des weiteren Bauteils anlegen. Das erste Verbindungselement kann insbesondere als laminierte Struktur oder als flexible Platte ausgebildet sein.

Gemäß einem wesentlichen Aspekt der vorliegenden Erfindung ist es vorgesehen, dass das Halbleitermodul zusätzlich zu dem ersten Verbindungselement ein zweites Verbindungselement aufweist. Auch dieses zweite Verbindungselement dient zum elektrischen Verbinden des Halbleiterchips mit der Leiterbahn und/oder dem weiteren Bauelement. Dabei ist das zweite Verbindungselement als Draht oder als Band ausgebildet. Es kann auch vorgesehen sein, dass das zweite Verbindungselement mehrere Drähte und/oder Bänder aufweist. Beispielsweise kann das zweite Verbindungselement als Bonddraht ausgebildet sein. Alternativ dazu kann das zweite Verbindungselement als Band (ribbon) ausgebildet sein. Durch das zweite Verbindungselement wird die Stromtragfähigkeit des ersten Verbindungselements deutlich verbessert. Dabei dient das erste Verbindungselement insbesondere dazu, einen niederinduktiven Kommutierungspfad bereitzustellen, wodurch die Schaltverluste im Halbleiterchip minimiert werden. Zudem bringt das erste Verbindungselement den Vorteil der geringen elektromagnetischen Störungen während der Schaltvorgänge mit sich. Durch das zweite Verbindungselement wird die Stromtragfähigkeit der elektrischen Verbindung zwischen dem Halbleiterchip und der Leiterbahn und/oder dem weiteren Bauelement erhöht. Somit kann insgesamt eine zuverlässigere elektrische Verbindung für den Halbleiterchip bereitgestellt werden.

Bevorzugt ist das zweite Verbindungselement auf einer dem Halbleiterchip abgewandten Seite des ersten Verbindungselements angeordnet. Der Draht oder das Band wird also als paralleler Strompfad oberhalb des ersten Verbindungselements angebracht. Dies führt zu geringeren Temperaturhüben der Bonddrähte bzw. Bänder. Zudem wird der Draht oder das Band elektrisch mit dem ersten Verbindungselement verbunden. Somit kann eine verbesserte Kontaktierung des Drahts oder des Bandes erreicht werden. Wenn nur ein Draht oder ein Band ohne das erste Verbindungselement verwendet wird, werden diese üblicherweise direkt mit dem Halbleiterchip verbunden. Durch die dabei entstehende relativ geringe Kontaktfläche können Beschädigungen auftreten. Somit kann eine robuste elektrische Verbindung bereitgestellt werden.

In einer Ausführungsform umfasst das erste Verbindungselement eine elektrisch isolierende Folie und eine auf der Folie aufgebrachte Metallschicht. Beispielsweise kann das erste Verbindungselement mithilfe des sogenannten SiPLIT®-Verfahrens bereitgestellt werden (SiPLIT - Siemens Planar Interconnect Technology). Hierbei kann zunächst die elektrisch isolierende Folie derart auf den Halbleiterchip, das Substrat sowie die Leiterbahn und/oder das weitere Bauelement aufgebracht werden, dass diese an diesen Komponenten anliegt. Anschließend kann die Folie entsprechend strukturiert werden. Auf diese Folie kann dann die Metallschicht aufgebracht werden. Es kann auch vorgesehen sein, dass das erste Verbindungselement mithilfe der sogenannten Skin®-Technologie bereitgestellt wird. Hierbei kann die Metallschicht Sinterverfahrens auf eine Folie aufgebracht werden. Damit können bekannte Verfahren zur Herstellung des ersten Verbindungselements genutzt werden.

Gemäß einer weiteren Ausführungsform kann das erste Verbindungselement flexibel ausgebildet sein. Grundsätzlich kann das erste Verbindungselement dadurch bereitgestellt werden, dass eine flexible, elektrisch leitfähige Platte auf die zu verbindenden Komponenten des Halbleitermoduls aufgebracht wird. Somit kann beispielsweise die Kontaktfläche bei der elektrischen Verbindung deutlich erhöht werden. Des Weiteren können Ausdehnungen in Abhängigkeit von Temperaturschwankungen zuverlässig ausgeglichen werden.

Zudem ist es vorteilhaft, wenn das zweite Verbindungselement zumindest bereichsweise eine vorbestimmte Krümmung aufweist. Mit anderen Worten kann der Draht oder das Band bereichsweise bogenförmig ausgebildet. Durch diese Ausgestaltung des zweiten Verbindungselements kann erreicht werden, dass dieses eine gewisse Elastizität aufweist. Somit können Ausdehnungen der einzelnen Komponenten des Halbleitermoduls infolge von Temperaturunterschiede ausgeglichen werden.

Gemäß einer weiteren Ausführungsform weist das Halbleitermodul zumindest ein Isolationselement auf, welches zwischen dem Halbleiterchip und dem ersten Verbindungselement angeordnet ist. Dieses Isolationselement ist bevorzugt aus einem elektrisch isolierenden Material gefertigt. Insbesondere kann dieses Isolationselement an den Randbereichen des Halbleiterchips angeordnet sein. An den Randbereichen des Halbleiterchips befinden sich entsprechende Strukturen des Halbleiterchips, welche für die Sperrfähigkeit verantwortlich sind. Durch das Isolationselement kann verhindert werden, dass diese Strukturen elektrisch verbunden werden. Somit kann mithilfe des Isolationselements eine zuverlässige Randisolierung bereitgestellt werden.

Weiterhin ist es vorteilhaft, wenn das Halbleitermodul eine Bodenplatte aufweist, welche auf einer dem Halbleiterchip abgewandten Seite des Substrats mit dem Substrat verbunden ist. Beispielsweise kann die Bodenplatte aus einem Metall gebildet sein. Die Bodenplatte kann auch aus einem Material gebildet sein, welches Siliziumcarbid und/oder Aluminium umfasst. Mithilfe der Bodenplatte kann die im Betrieb des Halbleitermoduls bzw. des Halbleiterchips entstehende Wärme zuverlässig abgeführt werden.

Darüber hinaus kann es vorgesehen sein, dass das Halbleitermodul Steuerkreise aufweist. In diesen Steuerkreisen kann dann nur das erste Verbindungselement zur elektrischen Verbindung verwendet werden. In diesen Steuerkreisen liegt üblicherweise eine niedrigere Strombelastung vor. Somit sind elektromagnetische Störungen oder Beeinflussungen ausgeschlossen bzw. minimiert.

Das Halbleitermodul kann in einer Leistungselektronik oder einer anderen Elektronikkomponente verwendet werden. Es kann auch vorgesehen sein, dass die Leistungselektronik bzw. die Elektronikkomponente eine Mehrzahl von Halbleitermodulen umfasst. Der Halbleiterchip kann insbesondere als Transistor, beispielsweise als MOSFET oder als IGBT ausgebildet sein. Der Halbleiterchip kann auch als Leistungshalbleiterbauelement ausgebildet sein.

Ein erfindungsgemäßes Verfahren dient zum Herstellen eines Halbleitermoduls. Hierbei wird ein Substrat bereitgestellt. Des Weiteren wird auf dem Substrat ein Halbleiterchip angeordnet. Ferner wird ein erstes Verbindungselement zum elektrischen Verbinden des Halbleiterchips mit einer Leiterbahn und/oder einem weiteren Bauelement des Halbleitermoduls derart bereitgestellt, dass das erste Verbindungselement zumindest bereichsweise flächig an dem Halbleiterchip und dem Substrat sowie der Leiterbahn und/oder dem weiteren Bauelement anliegt. Darüber hinaus wird ein zweites Verbindungselement zum elektrischen Verbinden des Halbleiterchips mit der Leiterbahn und/oder dem weiteren Bauelement bereitgestellt, wobei das zweite Verbindungselement als Draht oder als Band ausgebildet ist. Mithilfe des erfindungsgemäßen Verfahrens kann ein erfindungsgemäßes Halbleitermodul hergestellt werden.

Dabei ist es insbesondere vorgesehen, dass zunächst das erste Verbindungselement zumindest bereichsweise auf den Halbleiterchip und das Substrat sowie auf die Leiterbahn und/oder das weitere Bauelement aufgebracht wird und anschließend das zweite Verbindungselement zumindest bereichsweise auf das erste Verbindungselement aufgebracht wird. Somit kann das erste Verbindungselement im Vergleich zu bekannten ersten Verbindungselementen bzw. flexiblen Platten mit einer geringeren Schichtdicke ausgebildet werden. Dadurch wird der Prozess der Fertigung vereinfacht. Des Weiteren weist das erste Verbindungselement im Vergleich zu bekannten Verbindungselementen eine höhere Elastizität auf und kann zudem besser auf die Oberfläche des Halbleiterchips aufgebracht werden. Zudem kann eine zuverlässige Verbindung zwischen dem ersten Verbindungselement und dem Halbleiterchip auch bei unterschiedlichen thermischen Ausdehnungskoeffizienten garantiert werden. Somit kann insgesamt eine robuste und zuverlässige Verbindung bereitgestellt werden.

Gemäß einer weiteren Ausführungsform wird zum Bereitstellen des ersten Verbindungselements eine Metallschicht mittels Sintern, Löten und/oder Galvanotechnik auf eine Folie aufgebracht. Wie bereits erläutert, kann das erste Verbindungselement als lamentierte Struktur oder als flexible Platte ausgebildet sein. Das erste Verbindungselement kann die elektrisch isolierende Folie umfassen, auf welcher die Metallschicht aufgebracht wird. Die Metallschicht kann beispielsweise aus Kupfer, Aluminium, Gold oder dergleichen gefertigt sein. Somit kann auf einfache und zuverlässige Weise das erste Verbindungselement hergestellt werden.

Die mit Bezug auf das erfindungsgemäße Halbleitermodul vorgestellten bevorzugten Ausführungsformen und deren Vorteile gelten entsprechend für das erfindungsgemäße Verfahren.

Die Erfindung wird nun anhand von bevorzugten Ausführungsbeispielen sowie unter Bezugnahme auf die beigefügten Zeichnungen näher erläutert. Dabei zeigen:
- FIG 1: ein Halbleitermodul gemäß dem Stand der Technik in einer ersten Ausführungsform;
- FIG 2: ein Halbleitermodul gemäß dem Stand der Technik in einer weiteren Ausführungsform; und
- FIG 3: ein Halbleitermodul gemäß einer Ausführungsform der vorliegenden Erfindung.

In den Figuren werden gleiche und funktionsgleiche Elemente mit den gleichen Bezugszeichen versehen.

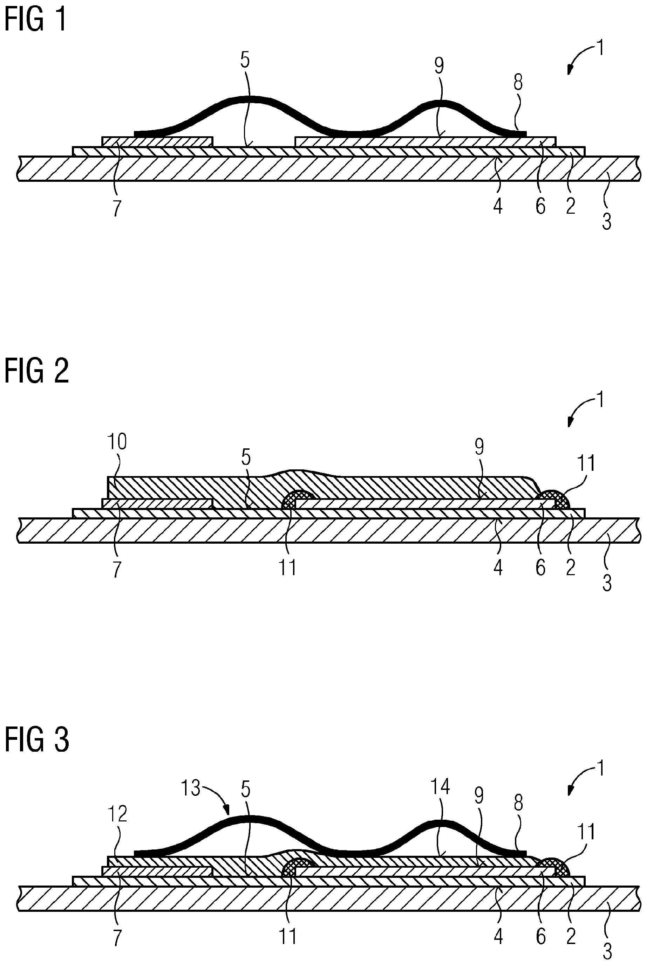

FIG 1 zeigt ein Halbleitermodul 1 gemäß dem Stand der Technik in einer ersten Ausführungsform. Dabei ist das Halbleitermodul 1 in einer geschnittenen Seitenansicht gezeigt. Das Halbleitermodul 1 umfasst ein Substrat 2, welches aus einem elektrisch isolierenden Material gebildet ist. Beispielsweise kann das Substrat 2 aus einer Keramik gebildet sein kann. Des Weiteren umfasst das Halbleitermodul 1 eine Bodenplatte 3, welche mit einer Unterseite 4 des Substrats 2 verbunden ist. Die Bodenplatte 3 kann aus einem Metall gebildet sein. Auf einer Oberseite 5 des Substrats 2 befindet sich ein Halbleiterchip 6. Der Halbleiterchip 6 kann auch als die bezeichnet werden. Darüber hinaus befindet sich auf der Oberseite 5 des Substrats 2 eine Leiterbahn 7. Dabei ist der Halbleiterchip 6 elektrisch mit der Leiterbahn mittels eines Bonddrahtes 8 verbunden. Dabei ist der Bonddraht 8 auf einer Oberseite 9 des Halbleiterchips 6 angeordnet. Der Halbleiterchip 6 kann zudem auf seiner Unterseite mit einer leitenden Schicht elektrisch verbunden sein. Über diese leitende Schicht kann der Halbleiterchip 6 mit einem weiteren Bauelement verbunden sein oder dieses ansteuern.

FIG 2 zeigt ein Halbleitermodul 1 gemäß dem Stand der Technik in einer weiteren Ausführungsform. Im Vergleich zu dem Halbleitermodul 1 gemäß FIG 1 sind der Halbleiterchip 6 und die Leiterbahn 7 mit einem flexiblen Verbindungselement 10 miteinander verbunden. Dieses flexible Verbindungselement 10 liegt flächig auf Bereichen des Halbleiterchips 6, des Substrats 2 sowie der Leiterbahn 7 auf. Das Verbindungselement 10 kann beispielsweise dadurch bereitgestellt werden, dass eine Folie auf die Leiterbahn 7, das Substrat 2 und den Halbleiterchip 6 aufgebracht wird. Anschließend kann diese Folie entsprechend strukturiert werden. Auf die strukturierte Folie kann dann eine Metallschicht aufgebracht werden. Es kann auch vorgesehen sein, dass das Verbindungselement 10 als flexible, elektrisch leitende Platte ausgebildetes, welche auf die Leiterbahn 7, das Substrat 2 sowie den Halbleiterchip 6 aufgebracht wird. Darüber hinaus sind Isolationselemente 11 vorgesehen, welche zwischen dem Halbleiterchip 6 und dem Verbindungselement 10 angeordnet sind. Diese Isolationselemente 11 dienen zur Randisolierung.

FIG 3 zeigt ein Halbleitermodul 1 gemäß einer Ausführungsform der Erfindung. Hierbei umfasst das Halbleitermodul ein erstes Verbindungselement 12, welches nach Art des Verbindungselements 11, welches in FIG 2 gezeigt ist, ausgebildet ist. Dabei weist das erste Verbindungselement 12 im Vergleich zu dem Verbindungselement 11 eine geringere Schichtdicke auf. Darüber hinaus weist das Halbleitermodul 1 ein zweites Verbindungselement 13 auf, welches vorliegend als Bonddraht 8 ausgebildet ist. Es kann auch vorgesehen sein, dass das zweite Verbindungselement 13 als Band ausgebildet ist. Dabei ist das zweite Verbindungselement auf eine Oberseite 14 des ersten Verbindungselements 12 aufgebracht.

Somit stellt das zweite Verbindungselement 13 bzw. der Bonddraht 8 einen parallelen Strompfad oberhalb der flexiblen Platte bzw. des ersten Verbindungselements 12 dar. Dabei bildet das erste Verbindungselement 12 einen niederinduktiven Kommutierungspfad, welcher für eine reibungslose Kommutierung in dem Halbleiterchip 6 sorgt. Durch das zweite Verbindungselement 13 bzw. den Bonddraht 6 kann die Stromtragfähigkeit erhöht werden. Somit kann eine zuverlässige und robuste elektrische Verbindung zwischen dem Halbleiterchip 6 und der Leiterbahn 7 bereitgestellt werden. Diese Verbindung kann auch dazu genutzt werden, den Halbleiterchip 6 mit weiteren Bauelementen des Halbleitermoduls 1 zu verbinden.

## Patentansprüche

1. Halbleitermodul (1) mit einem Substrat (2), mit einem Halbleiterchip (6), welcher auf dem Substrat (2) angeordnet ist, und mit einem ersten Verbindungselement (12) zum elektrischen Verbinden des Halbleiterchips (6) mit einer Leiterbahn (7) und/oder einem weiteren Bauelement des Halbleitermoduls (1), wobei das erste Verbindungselement (12) zumindest bereichsweise flächig an dem Halbleiterchip (6) und dem Substrat (2) sowie der Leiterbahn (7) und/oder dem weiteren Bauelement anliegt, **dadurch gekennzeichnet, dass** das Halbleitermodul (1) ein zweites Verbindungselement (13) zum elektrischen Verbinden des Halbleiterchips (6) mit der Leiterbahn (7) und/oder dem weiteren Bauelement aufweist, wobei das zweite Verbindungselement (13) als Draht oder als Band ausgebildet ist.

2. Halbleitermodul (1) nach Anspruch 1, **dadurch gekennzeichnet, dass** das zweite Verbindungselement (13) auf einer dem Halbleiterchip (6) abgewandten Seite (14) des ersten Verbindungselements (12) angeordnet ist.

3. Halbleitermodul (1) nach Anspruch 1 oder 2, **dadurch gekennzeichnet, dass** das erste Verbindungselement (12) eine elektrisch isolierende Folie und eine auf der Folie aufgebrachte Metallschicht umfasst.

4. Halbleitermodul (1) nach einem der vorhergehenden Ansprüche, **dadurch gekennzeichnet, dass** das erste Verbindungselement (12) flexibel ausgebildet ist.

5. Halbleitermodul (1) nach einem der vorhergehenden Ansprüche, **dadurch gekennzeichnet, dass** das zweite Verbindungselement (13) zumindest bereichsweise eine vorbestimmte Krümmung aufweist.

6. Halbleitermodul (1) nach einem der vorhergehenden Ansprüche, **dadurch gekennzeichnet, dass** das Halbleitermodul (6) zumindest ein Isolationselement (11) aufweist, welches zwischen dem Halbleiterchip (6) und dem ersten Verbindungselement (12) angeordnet ist.

7. Halbleitermodul (1) nach einem der vorhergehenden Ansprüche, **dadurch gekennzeichnet, dass** das Halbleitermodul (1) eine Bodenplatte (3) aufweist, welche auf einer dem Halbleiterchip (6) abgewandten Seite (4) des Substrats (2) mit dem Substrat (2) verbunden ist.

8. Verfahren zum Herstellen eines Halbleitermoduls (1), bei welchem ein Substrat (2) bereitgestellt wird, auf dem Substrat (2) ein Halbleiterchip (6) angeordnet wird und ein erstes Verbindungselement (12) zum elektrischen Verbinden des Halbleiterchips (6) mit einer Leiterbahn (7) und/oder einem weiteren Bauelement des Halbleitermoduls (1) derart bereitgestellt wird, dass das erste Verbindungselement (12) zumindest bereichsweise flächig an dem Halbleiterchip (6) und dem Substrat (2) sowie der Leiterbahn (7) und/oder dem weiteren Bauelement anliegt, **dadurch gekennzeichnet, dass** ein zweites Verbindungselement (13) zum elektrischen Verbinden des Halbleiterchips (6) mit der Leiterbahn (7) und/oder dem weiteren Bauelement bereitgestellt wird, wobei das zweite Verbindungselement (13) als Draht oder als Band ausgebildet ist.

9. Verfahren nach Anspruch 8, **dadurch gekennzeichnet, dass** zunächst das erste Verbindungselement (12) zumindest bereichsweise auf den Halbleiterchip (6) und das Substrat (2) sowie auf die Leiterbahn (7) und/oder das weitere Bauelement aufgebracht wird und anschließend das zweite Verbindungselement (13) zumindest bereichsweise auf das erste Verbindungselement (12) aufgebracht wird.

10. Verfahren nach Anspruch 8 oder 9, **dadurch gekennzeichnet, dass** zum Bereitstellen des ersten Verbindungselements (12) eine Metallschicht mittels Sintern, Löten und/oder Galvanotechnik auf eine Folie aufgebracht wird.
